(19) Europäisches Patentamt
European Patent Office
Office européen des brevets

(11) **EP 4 593 276 A1**

(12) **EUROPEAN PATENT APPLICATION**

(43) Date of publication:
**30.07.2025 Bulletin 2025/31**

(21) Application number: **25153812.0**

(22) Date of filing: **24.01.2025**

(51) International Patent Classification (IPC):
**H02M 3/156** (2006.01)    **H02M 1/00** (2006.01)
**H05B 45/30** (2020.01)    **H01S 5/068** (2006.01)

(52) Cooperative Patent Classification (CPC):
**H02M 3/1566; H01S 5/06808; H05B 45/30;**
H01S 5/0428; H01S 5/06226; H01S 5/183;
H02M 1/0016; H02M 1/0025

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **25.01.2024 US 202418422411**

(71) Applicant: **STMicroelectronics International N.V.
1228 Plan-les-Ouates, Geneva (CH)**

(72) Inventor: **MICHAL, Vratislav
38120 FONTANIL-CORNILLON (FR)**

(74) Representative: **Casalonga
Casalonga & Partners
Bayerstraße 71/73
80335 München (DE)**

(54) **TRANSIENT RESPONSE OF VCSEL DRIVERS**

(57) According to an embodiment, a feedback circuit for a power converter system is proposed. The feedback circuit includes an outer loop circuit and an inner loop circuit. The outer loop circuit includes a current estimator and a feedback controller. The current estimator is configured to generate a first voltage based on a difference between an output current of the power converter system and an average current at an inductor of the power converter system. The feedback controller is configured to generate an error signal as a difference between the first voltage and a desired setpoint voltage. The inner loop circuit is configured to generate a pulse width modulation (PWM) signal to operate switching elements of the power converter system based on the error signal.

FIG. 7

**Description**

**TECHNICAL FIELD**

The present disclosure generally relates to optical laser emitters and, in particular embodiments, to improving the transient response time of vertical-cavity surface-emitting laser (VCSEL) drivers for regulating the operation of the optical laser emitter.

**BACKGROUND**

Optical laser emitters are utilized in various technological applications due to their ability to deliver substantial amounts of power in an exceedingly brief duration. This capability, however, imposes rigorous demands on the precision and performance of the feedback mechanisms involved in their operation. A well-designed feedback loop is essential to ensure the power delivery is accurate and responsive, especially considering the rapid timescales on which laser emitters are expected to operate.

Traditionally, feedback loops, such as those implemented for regular feedback (FB) systems, have relied on the monitoring of either the vertical-cavity surface-emitting laser (VCSEL) current or the coil current to achieve regulation of the laser output current. When the VCSEL current is regulated, an output pole created by the VCSEL and the output capacitor creates a significant delay in the time response, with reaction speeds being hindered to levels slower than, for example, 4 microseconds. This pole makes the implementation of the fast feedback loop difficult. The resulting speed reduction is disadvantageous for applications requiring fast laser intensity modulation.

Conversely, when inductor current regulation feedback loops are employed, a large amount of power is directed to the output capacitor ($C_{OUT}$) during the transient event. It results in an undesirable slow rise of the current within the VCSEL. The increase in current takes longer to reach the expected level within the VCSEL because the output capacitor absorbs the current. This detracts from the overall efficiency and effectiveness of the laser emitter in rapid-response situations. It is desirable to address these deficiencies in the conventional solutions.

**SUMMARY**

Technical advantages are generally achieved by embodiments of this disclosure, which describe a solution to improving the transient response time of vertical-cavity surface-emitting laser (VCSEL) drivers for regulating the operation of the optical laser emitter.

A first aspect relates to a feedback circuit for a power converter system. The feedback circuit includes an outer loop circuit and an inner loop circuit. The outer loop circuit includes a current estimator and a feedback controller. The current estimator is configured to generate a first voltage based on a difference between an output current of the power converter system and an average current at an inductor of the power converter system. The feedback controller is configured to generate an error signal as a difference between the first voltage and a desired setpoint voltage. The inner loop circuit is configured to generate a pulse width modulation (PWM) signal to operate switching elements of the power converter system based on the error signal.

A second aspect relates to a feedback circuit for a power converter system. The feedback circuit includes an outer loop circuit and an inner loop circuit. The outer loop circuit includes a current estimator and a feedback controller. The current estimator is configured to generate a first voltage based on a difference between an output current of the power converter system and a desired setpoint voltage. The feedback controller is configured to generate an error signal as a difference between the first voltage and an average current at an inductor of the power converter system. The inner loop circuit is configured to generate a pulse width modulation (PWM) signal to operate switching elements of the power converter system based on the error signal.

A third aspect relates to a power converter system. The power converter system includes a DC-DC power stage and a feedback circuit. The DC-DC power stage includes switching elements and an inductor. The switching elements include a high-side switch and a low-side switch. A shared terminal of the high-side switch and the low-side switch is coupled to a first terminal of the inductor. A second terminal of the inductor is coupled to a load of the power converter system. The feedback circuit is configured to regulate an output current of the DC-DC power stage for the load. The feedback circuit includes an outer loop circuit and an in inner loop circuit. The outer loop circuit includes a current estimator and a feedback controller. The current estimator is configured to generate a first voltage based on a difference between the output current and an average current at the inductor or based on a difference between the output and a desired setpoint voltage. The feedback controller is configured to generate an error signal as a difference between the first voltage and the desired setpoint voltage or as a difference between the first voltage and the average current at the inductor. The inner loop circuit is configured to generate a pulse width modulation (PWM) signal to operate switching elements of the power converter system based on the error signal.

Embodiments can be implemented in hardware, software, or any combination thereof.

## BRIEF DESCRIPTION OF THE DRAWINGS

For a more complete understanding of the present disclosure and the advantages thereof, reference is now made to the following descriptions taken in conjunction with the accompanying drawings, in which:

Figure 1 is a block diagram of a circuit configured as a constant output current converter in, for example, a switch-mode power supply (SMPS);

Figure 2 is a schematic of a feedback circuit based on peak current mode control;

Figure 3 is a schematic of a proportional integral (PI) regulator;

Figure 4 is a block diagram of an embodiment control system;

Figures 5A-B and 6A-B are Bode plots;

Figure 7 is a block diagram of an embodiment power converter system;

Figure 8 is a block diagram of an embodiment control system;

Figure 9 is a block diagram of an embodiment feedback outer loop ($F_{OL}$);

Figure 10 is a block diagram of an embodiment feedback outer loop ($F_{OL}$);

Figure 11 is a schematic of an embodiment representing a current estimator circuit;

Figure 12 is a schematic of an embodiment current estimator circuit;

Figure 13 is a block diagram of a feedback outer loop ($F_{OL}$);

Figure 14 is a block diagram of a feedback outer loop ($F_{OL}$); and

Figure 15 is a schematic of an embodiment symmetrical feedback controller.

## DETAILED DESCRIPTION OF ILLUSTRATIVE EMBODIMENTS

This disclosure provides many applicable inventive concepts that can be embodied in a wide variety of specific contexts. The particular embodiments are merely illustrative of specific configurations and do not limit the scope of the claimed embodiments. Features from different embodiments may be combined to form further embodiments unless noted otherwise. Various embodiments are illustrated in the accompanying drawing figures, where the same reference number identifies identical components and elements, and repetitive descriptions are omitted for brevity.

Variations or modifications described in one of the embodiments may also apply to others. Further, various changes, substitutions, and alterations can be made herein without departing from the spirit and scope of this disclosure as defined by the appended claims.

While the inventive aspects are described primarily in the context of a buck converter, it should also be appreciated that these inventive aspects may also apply to any general type of DC-DC converter.

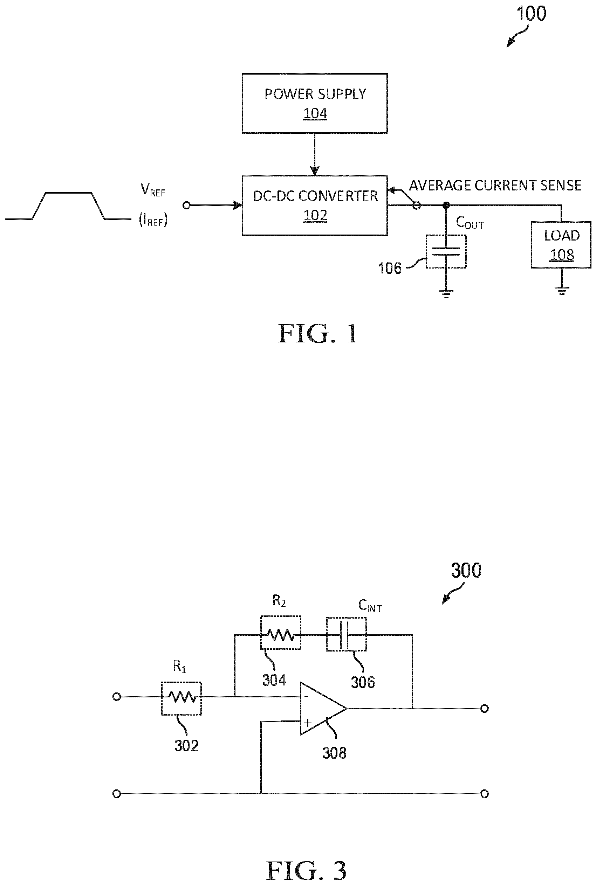

Figure 1 illustrates a block diagram of a circuit 100 configured as a constant output current converter in, for example, a switch-mode power supply (SMPS). Circuit 100 includes a DC-DC converter 102, a power supply 104, an output capacitor ($C_{OUT}$) 106, and a load 108, which may (or may not) be arranged as shown. Circuit 100 may include additional components not shown, such as an inductive element at the output of the DC-DC converter 102 and before the output capacitor ($C_{OUT}$) 106 to, for example, store energy (e.g., in a buck converter or a boost converter).

DC-DC converter 102 converts a source of direct current (DC) from one voltage level to another. They are used in various applications where voltage levels must be stepped up (boost converter), stepped down (buck converter), or even inverted. These converters are essential in providing the correct voltage and current to electronic devices and ensuring their safe and efficient operation. In embodiments, DC-DC converter 102 is a buck peak current mode DC to DC type converter.

The DC-DC converter 102 is coupled to the power supply 104, which provides the voltage to the DC-DC converter 102. As shown, the DC-DC converter 102 has a reference input, which receives a reference signal (i.e., $V_{REF}$ or $I_{REF}$) that drives the DC-DC converter 102. The output of the DC-DC converter 102 is coupled to the output capacitor ($C_{OUT}$) 106 and the load 108. Accordingly, the DC-DC converter 102 delivers a regulated output current to the output capacitor ($C_{OUT}$) 106 and the load 108, based on the reference signal at the reference input.

The output capacitor ($C_{OUT}$) 106 provides a reservoir of energy that can be called upon when there is a transient increase in the demand of the load 108. It stores energy when the power draw is less than what the DC-DC converter 102 is putting out and releases it quickly when the demand momentarily exceeds the current being supplied.

The output capacitor ($C_{OUT}$) 106 smoothens out any voltage ripple that is produced by the switching action of the DC-DC converter 102. Ripple is inherent in switching converters due to the periodic energy accumulation and release of an inductive element, typically an inductor or transformer. Although the constant current regulation mode aims to regulate load current, the output capacitor ensures that the voltage remains relatively stable for all switching phases of the DC-DC converter.

Further, the output capacitor ($C_{OUT}$) 106 provides a buffer against load transientssudden changes in load 108 that cause quick current and voltage changes. The output capacitor ($C_{OUT}$) 106 can respond to these abrupt shifts and prevent immediate output disruption.

Moreover, the output capacitor ($C_{OUT}$) 106 can stabilize the feedback control loop used in constant-current converters. The value and characteristics of the output capacitor ($C_{OUT}$) 106 influence how quickly and smoothly the DC-DC converter 102 can respond to variations in load 108 and input reference voltage, affecting system stability and preventing oscillations or other instabilities.

In embodiments, load 108 is a vertical-cavity surface-emitting laser (VCSEL) coupled to the VCSEL driver. The DC-DC converter 102 provides a constant current output to drive the VCSEL. Generally, the VCSEL requires a stable current source to maintain consistent optical output and preserve the laser diode's lifespan. Ensuring a constant current is essential, as variations can lead to fluctuations in light intensity and potentially damage the laser diode.

Regulating the coil current ($I_{COIL}$) of the DC-DC converter 102 to equal the output current ($I_{VCSEL}$) provided to the VCSEL is desirable, typically determined and set using a feedback circuit. It allows the utilization of only one current sensing element in the output current path.

In the conventional feedback circuit, a current sensing element at the VCSEL introduces an additional pole into the feedback path of the circuit 100-originating from the VCSEL resistance and output capacitor ($C_{OUT}$) 106, creating a low-pass filter effect. Such a filter effect is often represented in the frequency domain by a "pole." The presence of the additional pole generated by the VCSEL and output capacitor ($C_{OUT}$) 106 results in a delay, which is difficult to overcome by even a fast feedback controller. Disadvantageously, it slows the current rise of the output current ($I_{VCSEL}$) (i.e., slows down the response time) to more than several microseconds.

Further, as another approach in the traditional feedback circuit, when a pulsed reference signal is applied to drive the DC-DC converter 102, it initiates a process of regulating the current flowing through its output inductor, which in turn raises the output voltage. This rise in output voltage results from driving the desired current through load 108. However, this second approach's notable drawback is the uncontrolled parasitic current concurrently driving in the output capacitor ($C_{OUT}$) 106.

The regulation mechanism of the feedback circuit within DC-DC converter 102 aims to maintain the coil current ($I_{COIL}$) in line with the load current. However, since direct measurement of the load current at the optical laser emitter is often not feasible, as discussed above regarding the additional pole and increased lag time, and the need for an additional current sensor, the current that goes into charging and discharging the output capacitor ($C_{OUT}$) 106 introduces ambiguity. This additional flow of current results in uncertainty regarding the actual amount of current being delivered to the load 108, considering that an unmeasured portion of the total current is being diverted into the output capacitor ($C_{OUT}$) 106. Consequently, ensuring precise control of the current supplied to the VCSEL during current rise and fall intervals becomes complex, potentially affecting the performance and reliability of the laser operation.

Further, VCSEL drivers typically require fast response times to modulate the laser output. Accordingly, the DC-DC converter 102 must be capable of providing high-frequency pulsating power to ensure that the rise and fall times are within one to several microseconds. The output capacitor ($C_{OUT}$) 106 substantially impacts the performance characteristics of the current supplied to the VCSEL. For example, when the capacitance of the output capacitor ($C_{OUT}$) 106 is increased, a beneficial decrease is observed in the ripple of the output current ($I_{VCSEL}$), which is the current that feeds the VCSEL. This ripple reduction is advantageous for the stable operation of the VCSEL, as excessive ripple can lead to unwanted noise and instability in the laser output.

However, an increase in the capacitance of the output capacitor ($C_{OUT}$) 106 comes with a trade-off. Specifically, there is a consequential effect on the dynamic response of the output current ($I_{VCSEL}$). As the capacitance value rises, it takes a longer time for the output current ($I_{VCSEL}$) to increase to its desired value (i.e., a slower rise time for output current ($I_{VCSEL}$)) because the substantially high current is absorbed by the output capacitor ($C_{OUT}$) 106. This increased capacitance introduces a larger time constant into the circuit 100, creating a more sluggish response to changes in demand from the converter's control system.

Conversely, a decrease in the capacitance of the output capacitor ($C_{OUT}$) 106 results in a quicker response time, allowing the output current ($I_{VCSEL}$) to attain its requisite value more rapidly, thus providing a faster rise time. However, a smaller capacitance of the output capacitor ($C_{OUT}$) 106 leads to less effective suppression of the switching ripple of the DC-DC converter 102 in the output current ($I_{VCSEL}$). The increased ripple level may compromise the VCSEL's operational stability by introducing undesirable noise and fluctuations in the laser output.

Accordingly, as the output capacitor ($C_{OUT}$) 106 beneficially acts to reduce the ripple at the output current ($I_{VCSEL}$) provided to the VCSEL, the ambiguity added to the parasitic current concurrently generated in the output capacitor ($C_{OUT}$) 106 adds to the complexity in providing the fast-rising time of the load current of the DC-DC converter 102.

In embodiments, a solution to the limitations in conventional feedback circuits is proposed, which employs a feedback technique predicated on the estimation and appropriate weighting of the output capacitor current ($I_{COUT}$) when only sensing the coil current ($I_{COIL}$). The introduction of an additional pole into the system is compensated by adding a variable gain stage, which introduces a neighboring zero into the transfer function, providing sufficient compensation for the pole. Consequently, the proposed approach dramatically improves the rise-time performance of the output current ($I_{VCSEL}$) provided to the VCSEL, achieving rise times as swift as 1 microsecond. These and additional features are further detailed below.

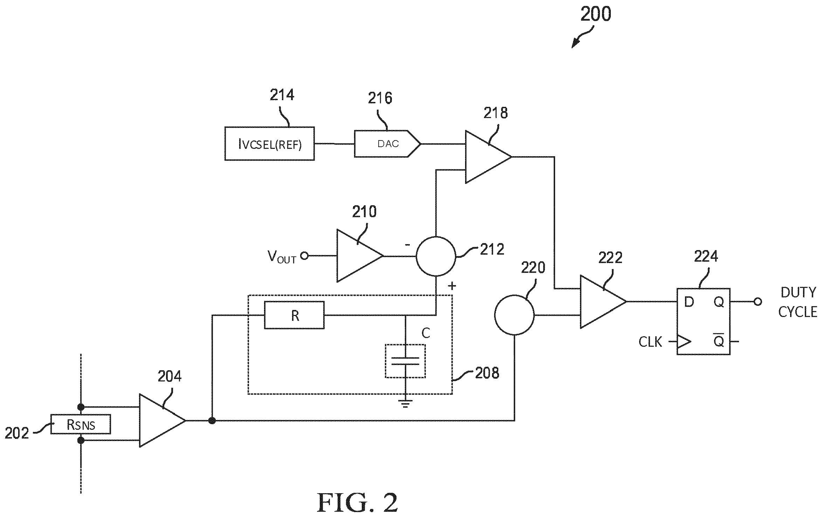

Figure 2 illustrates a schematic of a feedback circuit 200 based on peak current mode control, which may be combined with circuit 100. As shown, the feedback circuit 200 includes a sense resistor 202, a first differential amplifier 204, a low-pass filter 208, a capacitive current estimator 210, a summer 212, a digital-to-analog converter (DAC) 216-providing a reference value, a linear feedback controller 218, a ramp compensator circuit 220, a PWM comparator 222, and a flip-flop 224, which may (or may not) be arranged as shown. The feedback circuit 200 may include additional components not shown.

The feedback circuit 200 is configured to monitor the coil current ($I_{COIL}$) to maintain the set point of current irrespective of varying input voltage or changes in load 108 to achieve a constant output current operation.

In embodiments, the coil current ($I_{COIL}$) is regulated through a carefully designed control loop that senses peak and average current values. Initially, the sense resistor 202 is introduced into the current path of the coil current ($I_{COIL}$). The voltage across the sense resistor 202 indicates the instantaneous current flowing through it. This voltage is then fed to the first differential amplifier 204, responsible for sensing the peak current. By amplifying the voltage across the sense resistor 202, the first differential amplifier 204 provides a signal proportional to the peak current of the coil current ($I_{COIL}$).

The low-pass filter 208, coupled with the output of the first differential amplifier 204, transforms the peak current into an average current. The voltage on the output of the low-pass filter 208 is proportional to the current flowing through it but represents an averaged value rather than a real inductor current with an inductor ripple current at the switching frequency. The resulting voltage on the output of low-pass filter 208 reflects the average current through a time-averaged characteristic.

The capacitance of the output capacitor ($C_{OUT}$) 106 shapes the response of the output current regulation. The output voltage ($V_{OUT}$) on the output capacitor ($C_{OUT}$) 106 is shaped through the transfer function of the capacitive current estimator 210 and fed into the summer 212. Summer 212 has two inputs; the positive input receives the average current from the low-pass filter 208, and the negative input is connected to the amplified signal from the capacitive current estimator 210. Summer 212 effectively combines these signals to produce a signal corresponding to any deviation from the desired output current.

The summed signal is then provided to a linear feedback controller 218 as its first input. Additionally, reference current ($I_{VCSEL(REF)}$) 214 is converted to an analog signal by DAC 216. The output of the DAC 216 represents a reference current signal, constituting a second input to the linear feedback controller 218. This controller represents a so-called outer loop, known in the peak current mode control topology. In this system, the linear feedback controller 218 evaluates both inputs according to a predefined transfer function and executes adjustments to regulate the average output current. The control algorithm includes expressions outlining the determining duty cycle of the PWM for buck converters based on the peak coil current (Icon.).

In parallel to these processes, another branch from the first differential amplifier 204 feeds into a ramp compensator circuit 220. This signal assists in further stabilizing the inner control loop by guaranteeing the convergence of the inner loop for higher duty cycle values.

The subsequent stage involves a PWM comparator 222 having its first input coupled to the output of the ramp compensator circuit 220 and its second input receiving information from the linear feedback controller 218. When discrepancies between these signals arise, indicating divergence from favorable operating conditions, the output of the PWM comparator 222 is switched, which influences downstream timing circuitry.

The output of the PWM comparator 222 is fed into the data input (D) of the flip-flop 224, which also receives the clock signal (CLK) as an input, which ensures synchronous operation with system timing.

The output (Q) of the flip-flop 224 provides the switching PWM signal for the DC-DC converter 102. In a buck converter, it pertains to the ON time ($T_{ON}$) durations. This duty cycle management ensures that output current regulation satisfies transient response requirements and steady-state accuracy, maintaining desired performance levels across various operating conditions.

One advantage provided by the embodiments of this disclosure is a single current sensing element that can concurrently measure peak and average current and provide both average and peak current information.

Further, as the current ($I_{VCSEL}$) 214 provided to the VCSEL is no longer monitored, the additional circuitry of the capacitive current estimator 210 is used to establish an image of the output current ($I_{VCSEL}$) in the summer 212. This summing block realizes the function of the ideal equation $I_{COIL} = I'_{COUT} + I_{VCSEL}$. The input to the linear feedback controller is, therefore: $I'_{VCSEL} = I_{COIL} - I'_{COUT}$, where $I'_{COUT}$ is an estimation of $I_{COUT}$, and $I'_{VCSEL}$ is the estimated value of VCSEL current used for the regulation.

Figure 3 illustrates a schematic of a proportional integral (PI) regulator 300, which may be combined with circuit 100. As shown, PI regulator 300 includes a first resistor ($R_1$) 302, a second resistor ($R_2$) 304, a capacitor ($C_{INT}$) 306, and an operational amplifier 308, which may (or may not) be arranged as shown. PI regulator 300 may include additional components not shown.

In embodiments, the PI regulator 300 is configured to regulate the estimated coil current ($I'_{COIL}$) or the output current ($I_{VCSEL}$) provided to the VCSEL. The first resistor ($R_1$) 302 is responsible for determining the amount of feedback signal directly related to the instantaneous error in the system. This error is the difference between the desired output current and the actual output current sensed. By adjusting the resistance value of the first resistor ($R_1$) 302, the response rate to the error can be controlled.

The second resistor ($R_2$) 304 and the capacitor ($C_{INT}$) 306, arranged in series, form the integral portion of the control scheme. The capacitor ($C_{INT}$) 306, in conjunction with the second resistor (R2) 304, performs the task of error accumulation over time. It integrates the error signal, ensuring that even small, persistent errors that may not be immediately corrected are eventually brought to zero. The combination of the second resistor ($R_2$) 304 and the capacitor ($C_{INT}$) 306 defines the time response of the integral action. It balances out how quickly or slowly the controller will react to accumulated error signals.

The operational amplifier 308 includes a non-inverting input (+) and an inverting input (-). The inverting input (-) of the operational amplifier 308 is coupled to a shared node between a first terminal of the first resistor ($R_1$) 302 and a first terminal of the second resistor ($R_2$) 304. The non-inverting input (+) is coupled to a reference ground or a reference voltage, depending on the desired operating conditions of the operational amplifier 308 and the control loop. The output of the operational amplifier 308 is coupled to a second terminal of the capacitor ($C_{INT}$) 306.

The operational amplifier 308 scales up the small error signal to levels sufficient to make tangible adjustments to the output of the DC-DC converter 102. The shared node between the first resistor ($R_1$) 302 and the second resistor ($R_2$) 304 provides a path for the error signal to reach the inverting input (-). The output voltage or current (after being scaled and optionally inverted by additional circuit elements not shown) generates the error signal in combination with some reference.

The operational amplifier 308 generates the correction signal, which is then fed back into the control circuitry of the DC-DC converter 102, influencing its behavior to correct any deviations found in the output current. The proportional element of the signal ensures a swift response to changes, arresting rapid fluctuations in current. In contrast, the integral element systematically addresses gradual drifts or long-term disparities between the desired and actual currents.

The collaboration of these actions by the resistor-capacitor network and amplifier culminates in a finely tuned feedback system. The PI regulator 300 adjusts and maintains the output current of the DC-DC converter 102, yielding a stable and reliable power supply imperative for optimal performance and longevity of the VCSEL.

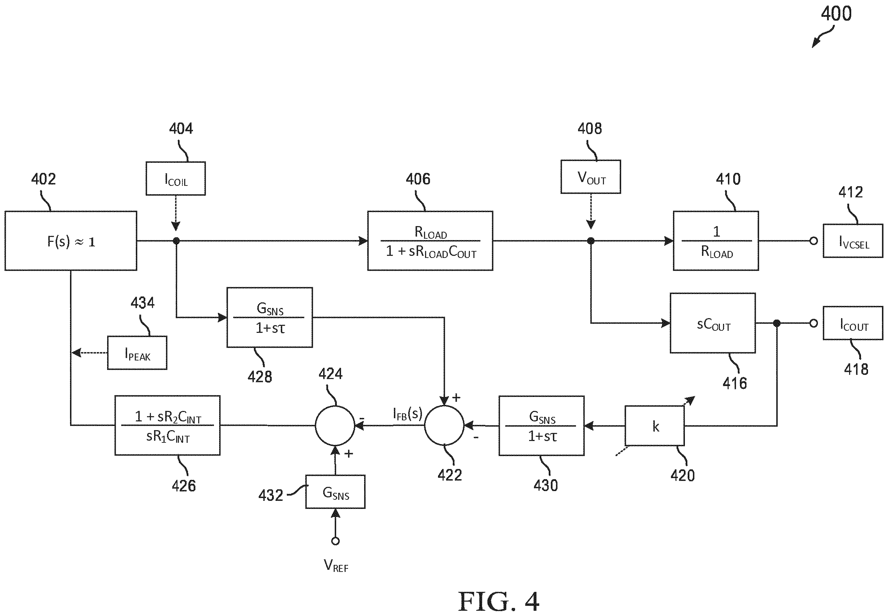

Figure 4 illustrates a block diagram of an embodiment control system 400. Control system 400 illustrates a proposed arrangement that allows indirect measurement of the output current ($I_{VCSEL}$) 412 provided to the VCSEL through subtraction of the coil current ($I_{COIL}$) 404 from the capacitor current ($I_{COUT}$) 418.

The control system 400 is described with reference to the symmetrical feedback controller 1500 in conjunction with the circuit 100. The various components illustrate different transfer functions, which provide relationships between the various inputs and outputs in the circuit 100.

It should be understood that the relationship between the capacitor current ($I_{COUT}$) 418 of the output capacitor ($C_{OUT}$) 106, the coil current ($I_{COIL}$) 404, and the output current ($I_{VCSEL}$) 412 provided to the VCSEL can be represented by the equation: $I_{COIL} = I_{VCSEL} + I_{COUT}$. Alternatively, the relationship can be represented as equation: $I_{VCSEL} = I_{COIL} - I_{COUT}$. Control system 400 effectively subtracts the coil current ($I_{COIL}$) from the capacitor current ($I_{COUT}$) to measure the output current ($I_{VCSEL}$) provided to the VCSEL indirectly. This subtraction is further controlled by a programmable k-factor 420. Switching frequency ripple is attenuated by a first filter (represented as transfer function 428) and a second filter (represented as transfer function 430) to provide an average value of the inductor current similar to the low-pass filter 208 in the control system 400.

In the frequency domain, the power stage and pulse width modulation (PWM) of the DC-DC converter 102 is represented as transfer function 402. The power stage converts the DC input voltage to the desired DC output voltage. It typically consists of switches (transistors such as MOSFETs), diodes, inductors, and capacitors. The configuration of these components can vary depending on the type of converter (e.g., buck, boost, buck-boost, etc.). The switches are turned on and off at high frequency, shaping the voltage and current to achieve the desired output.

The PWM controller dictates the operation of the power stage by controlling the timing of the switches of the power stage. The PWM controller generates a PWM signal, typically a square wave that switches between on (high voltage) and off (low voltage) states. The duty cycle of the PWM signal (the proportion of time the signal is high vs. low within each cycle) determines the average output voltage of the DC-DC converter 102 relative to its input.

In embodiments, the PWM controller operates such that the power stage has a transfer function 402 approximately equal to 1 (example for buck converter); this means it is configured to produce an output voltage very close to the input voltage multiplied by the duty cycle.

Transfer function 406 encapsulates the transformation of the average inductor current into output voltage $V_{OUT}$ 408, by the load 108 and the output capacitor ($C_{OUT}$) 106 under different operating conditions. The transfer function 406 of the circuit 100 in the frequency domain can be represented as the equation $(4.1)\text{: } \frac{R_{LOAD}}{1+sR_{LOAD}C_{OUT}}$ , where 's' is the complex frequency variable in the Laplace transform, $R_{LOAD}$ is the equivalent resistance value of the load 108 and output capacitor ($C_{OUT}$) 106 is the capacitance value of the output capacitor ($C_{OUT}$) 106. Transfer function 406 represents the impedance of the output of the DC-DC converter 102 (i.e. parallel connection of the output capacitor ($C_{OUT}$) 106 and the load 108).

The denominator in equation (4.1) introduces a pole into control system 400. It represents a first-order low-pass filter with a cutoff frequency at $\frac{1}{2\pi \, R_{LOAD}C_{OUT}}$ . This cutoff frequency determines how quickly the voltage across $R_{LOAD}$ can respond to changes. A higher cutoff frequency allows for a faster response, whereas a lower cutoff frequency results in a slower response.

At low frequencies (i.e., s approaches zero), the output behaves like a simple resistor with its output voltage proportional to any given current based on Ohm's Law (V = IR). This means that, under steady-state conditions, the output impedance of the DC-DC converter 102-as seen by the load 108-is essentially $R_{LOAD}$.

As the frequency increases, the capacitive reactance of the output capacitor ($C_{OUT}$) 106 comes into play more significantly. The term $sR_{LOAD}C_{OUT}$ grows, and consequently, the overall value of the impedance decreases. This effectively smooths out or filters high-frequency variations due to the capacitive effect that counters quick changes in voltage across the load 108.

Transfer function 406 describes how fluctuations in the coil current ($I_{COIL}$) due to changes commanded by the PWM controller or variations in input voltage or load 108 are translated into changes in the output voltage ($V_{OUT}$) by considering the electrical characteristics of the power stage components, including the dynamic interactions between inductor and capacitor during energy transfer. The output voltage ($V_{OUT}$) 408 behavior can be predicted by transfer function 406, which considers the effects of the $R_{LOAD}$ and the output capacitor ($C_{OUT}$) 106.

In the frequency domain, by providing the coil current (Icon.) 404 as an input to the transfer function 406, the output voltage ($V_{OUT}$) 408 can be represented as $V_{OUT}(s) = \frac{R_{LOAD}}{1+sR_{LOAD}C_{OUT}}I_{COIL}(s)$ .

The output current ($I_{VCSEL}$) 412 is directly proportional to the output voltage ($V_{OUT}$) 408 and inversely proportional to the resistance ($R_{LOAD}$) of load 108, expressed as $I_{VCSEL} = \frac{V_{OUT}}{R_{LOAD}}$ . Here, the conductance ($\frac{1}{R_{LOAD}}$) 410 indicates how current flow in circuit 100 increases with less resistance, and vice versa.

In the frequency domain, the transfer function 416, which describes how the capacitor current ($I_{COUT}$) 418 is related to its output voltage ($V_{OUT}$) 408, is represented as $sC_{OUT}$, which corresponds to the definition of the capacitor current as $I_{COUT} = C_{OUT}\frac{dV_{OUT}}{dt}$. By providing the output voltage ($V_{OUT}$) 408 as an input to the transfer function 416, the capacitor current ($I_{COUT}$) 418 can be represented as $I_{COUT}(s) = \frac{sR_{LOAD}C_{OUT}}{1+sR_{LOAD}C_{OUT}}I_{COIL}$ .

The capacitor current ($I_{COUT}$) 418 is provided as an input to the programmable k-factor 420. In future embodiments, the programmable k-factor 420 is implemented as a variable sense capacitor ($C_{SNS}$). It will be shown that this capacitor realizes the transfer function 416. The variable sense capacitor ($C_{SNS}$) allows the feedback loop to adjust its behavior based on the capacitance value, effectively becoming a tuning parameter or a programmable k-factor within the control system 400.

The variable sense capacitor ($C_{SNS}$) influences the impedance and, therefore, controls the dynamics of the feedback loop. The impedance of a capacitor is inversely related to both its capacitance and the frequency of the signal passing through it, as given by the expression Z = 1/(jωC), where ω is the angular frequency and C is the capacitance. By adjusting the capacitance of the variable sense capacitor ($C_{SNS}$) electronically-achieved, for example, by discrete programming of the capacitor value using switches, the effective gain k in the feedback loop can be varied.

The programmable $k$-factor 420, scales the image of the capacitor current ($I'_{COUT}$) 418 by a factor of $k$. Thus, the output of the programmable k-factor 420 is represented as: $kI_{COUT}(s)$ or $\frac{ksR_{LOAD}C_{OUT}}{1+sR_{LOAD}C_{OUT}}I_{COIL}$.

In embodiments, due to the ripple at the coil current ($I_{COIL}$) 404, a first filter with a gain of $G_{SNS}$ is introduced into the system, providing an average current image of the output current. Transfer function 428 for the first filter represents how the output of the first filter responds to its input, considering both the gain ($G_{SNS}$) and a time constant ($\tau$). The transfer function 428 of the first filter is represented as $\frac{G_{SNS}}{1+s\tau}$. The time constant ($\tau$) is a characteristic of a first-order system's response rate to changes to its input. Transfer function 428 for the first filter adds a pole, where the denominator $(1 + s\tau)$ represents a first-order lag. Accordingly, the transfer function 428 scales the coil current (Icon.) 404, such that the output of the transfer function 428 is represented as: $\frac{G_{SNS}}{1+s\tau}I_{COIL}$. In embodiments, the first filter has a gain between 0.01 and 2; in a particular embodiment, the first filter has a unity gain ($G_{SNS}$=1).

In embodiments, due to the ripple at the capacitor current ($I_{COUT}$) 418, a second filter with a gain of $G_{SNS}$ is introduced into the system. Transfer function 430 represents how the output of the second filter responds to its input. The transfer function 430 is represented as $\frac{G_{SNS}}{1+s\tau}$. Accordingly, the transfer function 430 scales the output of the programmable k-factor 420, such that the output of the transfer function 430 is represented as: $\frac{G_{SNS}}{1+s\tau}\frac{ksR_{LOAD}C_{OUT}}{1+sR_{LOAD}C_{OUT}}I_{COIL}$. In embodiments, the second filter has unity gain ($G_{SNS}$=1).

Adding the second pole by the second filter introduces further phase lag into the system's transfer function. This additional phase lag can become significant, moving the system closer to its stability margin. The cumulative effect of multiple poles can complicate system stabilization due to increased phase delay and the potential for reduced phase margin. Advantageously, the programmable k-factor 420 introduces an additional zero into the system and compensates for the additional pole from the output node impedance $(1+sR_{LOAD}C_{OUT})$ (i.e., reducing the phase shift to 90° or less).

In embodiments with the first filter and the second filter, the first summer 422 subtracts (i) the output of the transfer function 430 from (ii) the output of the transfer function 428 for the first filter, which provides a feedback current ($I_{FB}$) at its output. In the frequency domain, the feedback current ($I_{FB}$) is represented as:

$$I_{FB}(s) = \frac{G_{SNS}}{1+s\tau}I_{COIL}(s) - \frac{G_{SNS}}{1+s\tau}kI_{COUT}(s) = \frac{G_{SNS}}{1+s\tau}\frac{1+(1-k)sC_{OUT}R_{OUT}}{1+sC_{OUT}R_{OUT}}I_{coil}(s)$$

. This transfer function represents an estimated image of the VCSEL current ($I'_{VCSEL}$).

In embodiments without the first filter and the second filter, the first summer 422 subtracts (i) the output of the programmable k-factor 420 from (ii) the output of the transfer function 402, which provides a feedback current ($I_{FB}$) at its output. In the frequency domain, the feedback current ($I_{FB}$) is represented as:

$$I_{FB}(s) = I_{COIL}(s) - kI_{COUT}(s) = \frac{1+(1-k)sC_{OUT}R_{OUT}}{1+sC_{OUT}R_{OUT}}I_{coil}(s)$$

.

Accordingly, when $k$ is equal to zero (i.e., $k$=0), there is no zero in the transfer function, and the feedback current ($I_{FB}$) is represented as: $I_{FB}(s) = \frac{G_{SNS}}{1+s\tau}I_{COIL}(s)$ or, in the case without the first filter and the second filter, $I_{FB}(s) = I_{COIL}(s)$. This signifies that the estimation of the capacitor current is disabled. When $k$ is equal to one (i.e., $k$=1), the zero cancels out the pole introduced by $C_{OUT}R_{OUT}$ in the denominator, and the feedback current ($I_{FB}$) is represented by dual pole transfer function as: $I_{FB}(s) = \frac{G_{SNS}}{1+s}\frac{1}{1+sC_{OUT}R_{OUT}}I_{COIL}(s)$, or in the case without the first filter and the second filter, $I_{FB}(s) = \frac{1}{1+sC_{OUT}R_{OUT}}I_{COIL}(s)$ is a 1st order transfer function.

Accordingly, setting the variable factor $k$ within the range of zero to one is advisable to achieve optimal performance in the feedback regulation loop. This adjustment ensures the transfer function associated with the feedback current ($I_{FB}$) closely mirrors the output current ($I_{VCSEL}$) provided to the VCSEL while compensating for the slow pole $(1 + sC_{OUT}R_{OUT})$. The presence of a pole can be detrimental, as it not only slows the rise time of the output current ($I_{VCSEL}$) but also induces an additional phase shift. Such phase shift complicates the compensation process within the feedback loop, potentially impacting system stability and response.

The feedback current ($I_{FB}$) is fed to the second summer 424. The other input of the second summer 424 is the scaled version of the reference voltage ($V_{REF}$). The reference voltage ($V_{REF}$) is set based on the desired average current of

# EP 4 593 276 A1

the output current ($I_{VCSEL}$). A gain factor of $G_{SNS}$ scales the reference voltage ($V_{REF}$). The second summer 424 subtracts the feedback current ($I_{FB}$) from the scaled version of the reference voltage ($V_{REF}$). In embodiments, the second summer 424 and the transfer function 426, which is realized by the symmetrical feedback controller 1500.

Transfer function 426 of the PI regulator 300 in the frequency domain can be represented as equation:

$$\frac{1+sR_2C_{INT}}{sR_1C_{INT}}$$, where $R_1$ is the resistance value of the first resistor ($R_1$) 302, $R_2$ is the resistance value of the second resistor ($R_2$) 304, and $C_{INT}$ is the capacitance value of the capacitor ($C_{INT}$) 306. Transfer function 426 characterizes the behavior of the PI regulator 300 in terms of how it responds to different frequency components of a signal.

Accordingly, the open loop feedback ($FB_{OL}$) at the output of the transfer function 426 is:

$$FB_{OL}(s) = \frac{V_{FB}}{I_{COIL}} = \frac{1+sR_2C_{INT}}{sR_1C_{INT}} \frac{G_{SNS}}{1+s\tau} \frac{1+(1-k)sC_{OUT}R_{OUT}}{1+sC_{OUT}R_{OUT}}$$ with the first and second filters. Without the first filter and the second filter, open loop feedback ($FB_{OL}$) at the output of the transfer function 426 is:

$$FB_{OL}(s) = \frac{V_{FB}}{I_{COIL}} = \frac{1+sR_2C_{INT}}{sR_1C_{INT}} \frac{1+(1-k)sC_{OUT}R_{OUT}}{1+sC_{OUT}R_{OUT}}$$.

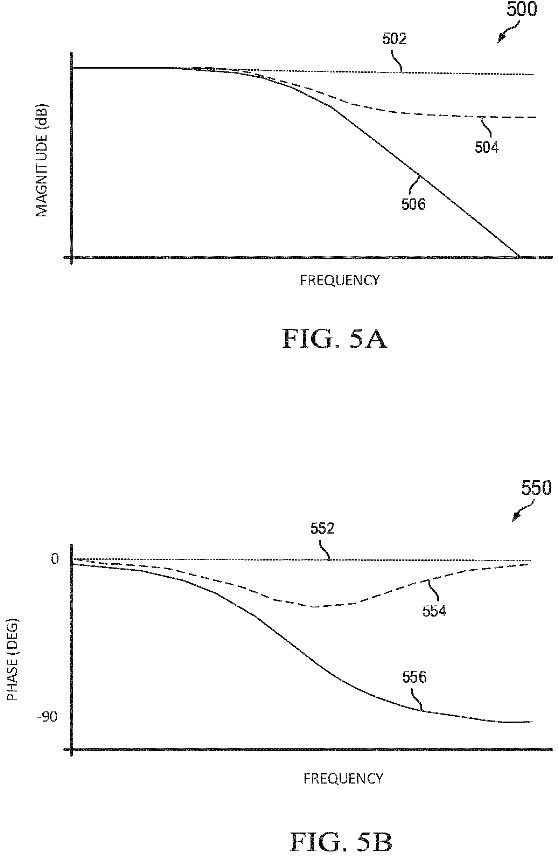

Figures 5A-B illustrate a Bode plot (Bode magnitude and phase plot) of the feedback current ($I_{FB}$) in a control system 400 without the first filter (represented as transfer function 428) and the second filter (represented as transfer function 430). As discussed in Figure 4, without the first filter and the second filter, the feedback current ($I_{FB}$) in the frequency domain, is represented as:

$$I_{FB}(s) = \frac{1+(1-k)sC_{OUT}R_{OUT}}{1+sC_{OUT}R_{OUT}} I_{coil}(s)$$. Advantageously, by using the programmable k-factor 420 and adjusting the variable k factor to have a zero transfer function, a zero is introduced that compensates against the 1st order lag from the pole introduced by $C_{OUT}R_{OUT}$ in the denominator of the feedback current ($I_{FB}$).

In Figure 5A, a Bode magnitude plot illustrates the magnitude (in dB) of the frequency response of the first feedback current ($I_{FB}$) 502 (k factor equal to '0'), the second feedback current ($I_{FB}$) 504 (k factor between '0' and '1'; for example, approximately equal to 0.5), and the third feedback current ($I_{FB}$) 506 (k factor equal to '1').

In Figure 5B, a Bode phase plot illustrates the phase shift (in degrees) of the frequency response of the first feedback current ($I_{FB}$) 552 (k factor equal to '0'), the second feedback current ($I_{FB}$) 554 (k factor between '0' and '1'; for example, approximately equal to 0.5), and the third feedback current ($I_{FB}$) 556 (k factor equal to '1').

For the first feedback current ($I_{FB}$) 502, the k factor is equal to '0', $I_{FB}(s) = I_{COIL}(s)$, and the frequency response remains at 0 dB across the frequency range. For the third feedback current ($I_{FB}$) 506, the k factor is equal to '1',

$$I_{FB}(s) = \frac{1}{1+sC_{OUT}R_{OUT}} I_{COIL}(s)$$, and the frequency response illustrates a -20 dB/dec magnitude drop due to the pole-corresponding in fact, to directly measuring the output current ($I_{VCSEL}$).

For the first feedback current ($I_{FB}$) 552, the k factor is equal to '0', $I_{FB}(s) = I_{COIL}(s)$, and the frequency response remains at 0 degrees across the frequency range. For the third feedback current ($I_{FB}$) 556, the k factor is equal to '1',

$$I_{FB}(s) = \frac{1}{1+sC_{OUT}R_{OUT}} I_{COIL}(s)$$, and the frequency response illustrates the 90 degrees phase shift due to the pole-corresponding to directly measuring the output current ($I_{VCSEL}$). As discussed previously, such a phase shift complicates, with additional phase shifts in the system, the compensation process within the feedback loop, potentially impacting system stability and response.

Accordingly, by setting the k factor to a value between '0' and '1', a zero is introduced that compensates against the 1st order lag from the pole introduced by $C_{OUT}R_{OUT}$ in the denominator of the feedback current ($I_{FB}$).

It can be observed through the second feedback current ($I_{FB}$) 504 that by setting the k factor to a value between '0' and '1', although the magnitude initially drops, it becomes stabilized as the frequency is increased. Moreover, by setting the k factor to a value between '0' and '1', the phase shift for the second feedback current ($I_{FB}$) 554 returns to zero, which is desirable.

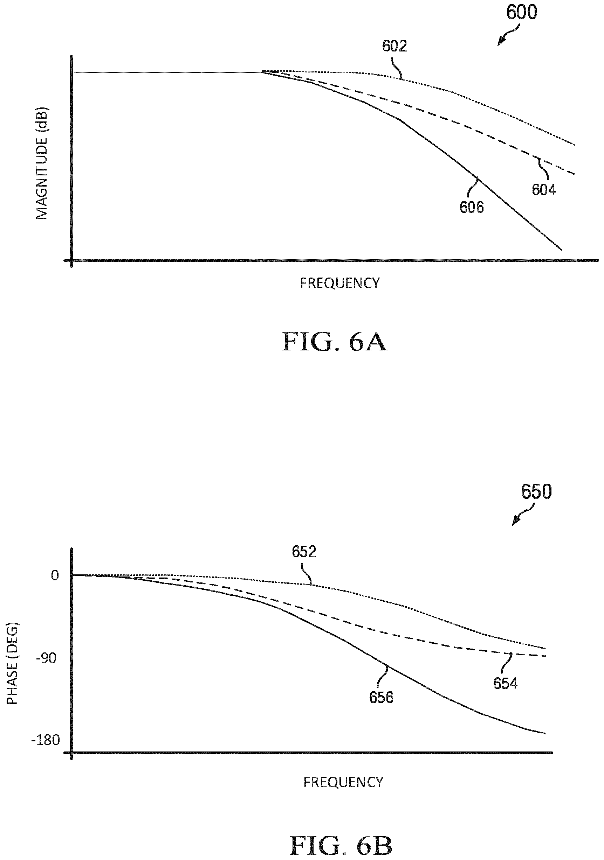

Figures 6A-B illustrate a Bode plot (Bode magnitude and phase plot) of the feedback current ($I_{FB}$) in a control system 400 with the first filter (represented as transfer function 428) and the second filter (represented as transfer function 430) included. As discussed in Figure 4, with the first filter and the second filter, the feedback current ($I_{FB}$) in the frequency domain, is represented as:

$$\frac{G_{SNS}}{1+s\tau} \frac{1+(1-k)sC_{OUT}R_{OUT}}{1+sC_{OUT}R_{OUT}} I_{coil}(s)$$. Advantageously, by using the programmable k-factor 420 and adjusting the variable k factor to have a zero transfer function, a zero is introduced that compensates against the 2nd order lag from the pole introduced by $C_{OUT}R_{OUT}$ the denominator of the feedback current ($I_{FB}$).

In Figure 6A, a Bode magnitude plot illustrates the magnitude (in dB) of the frequency response of the first feedback current ($I_{FB}$) 602 (*k* factor equal to '0'), the second feedback current ($I_{FB}$) 604 (*k* factor between '0' and '1'), and the third feedback current ($I_{FB}$) 606 (*k* factor equal to '1').

In Figure 6B, a Bode phase plot illustrates the phase shift (in degrees) of the frequency response of the first feedback current ($I_{FB}$) 652 (*k* factor equal to '0'), the second feedback current ($I_{FB}$) 654 (*k* factor between '0' and '1'), and the third feedback current ($I_{FB}$) 656 (*k* factor equal to '1').

For the first feedback current ($I_{FB}$) 602, the *k* factor is equal to '0', $I_{FB}(s) = \dfrac{G_{SNS}}{1+s\tau} I_{COIL}(s)$, and the frequency response has a first order lag across the frequency range. As the *k* factor equals zero, there is no information about the output capacitor current. For the third feedback current ($I_{FB}$) 606, the *k* factor is equal to '1',

$$I_{FB}(s) = \frac{G_{SNS}}{1+s\tau}\frac{1}{1+sC_{OUT}R_{OUT}} I_{COIL}(s)$$

, and the frequency response has a second order lag across the frequency range. This transfer function represents the output current ($I_{VCSEL}$), but while it contains two poles, it is difficult to stabilize.

For the first feedback current ($I_{FB}$) 652, the *k* factor is equal to '0', $I_{FB}(s) = \dfrac{G_{SNS}}{1+s\tau} I_{COIL}(s)$, and the frequency response has a first order lag across the frequency range. For the third feedback current ($I_{FB}$) 656, the *k* factor is equal to '1',

$$I_{FB}(s) = \frac{G_{SNS}}{1+s\tau}\frac{1}{1+sC_{OUT}R_{OUT}} I_{COIL}(s)$$

, and the frequency response illustrates the 180 degrees phase shift due to two poles in the transfer function.

Accordingly, by setting the *k* factor to a value between '0' and '1', a zero is introduced that compensates against the 1$^{st}$ order lag from one of the poles in the denominator of the feedback current ($I_{FB}$).

It can be observed through the second feedback current ($I_{FB}$) 604 that by setting the *k* factor to a value between '0' and '1', the magnitude drops by approximately -20 dB/dec as the frequency is increased. Moreover, by setting the *k* factor to a value between '0' and '1', the phase shift for the second feedback current ($I_{FB}$) 654 returns to 90 degrees, which is more desirable than compensating for a 180 degrees phase shift in the feedback loop.

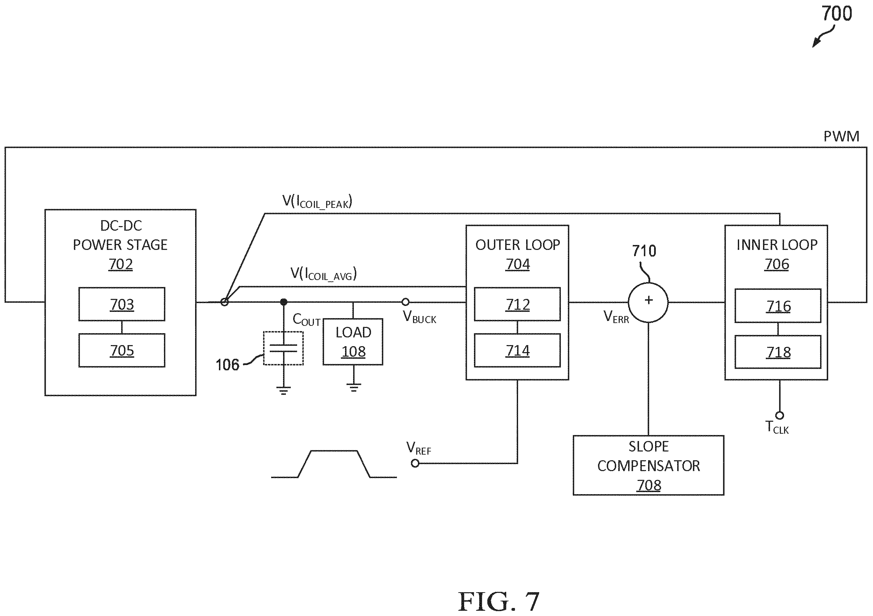

Figure 7 illustrates a block diagram of an embodiment power converter system 700 of a peak current mode feedback loop utilizing a sense capacitor ($C_{SNS}$) as a current estimator. Power converter system 700 includes a DC-DC power stage 702, a feedback outer loop ($F_{OL}$) 704, a feedback inner loop ($F_{IL}$) 706, a slope compensator 708, a summer 710, the output capacitor ($C_{OUT}$) 106, the load 108, which may (or may not) be arranged as shown. The power converter system 700 may include additional components that are not shown. Power converter system 700 is configured to regulate the current for load 108, which may include an optical laser emitter, such as a VCSEL.

In embodiments, DC-DC power stage 702 includes a switching circuit (e.g., high-side switch, low-side switch) 703 coupled to an inductor 705, as known in the art.

In embodiments, feedback outer loop ($F_{OL}$) 704 includes a current estimator 712 coupled to a feedback controller 714, which may or may not be arranged as shown. In embodiments, feedback outer loop ($F_{OL}$) 704 may include components not shown.

In embodiments, feedback outer loop ($F_{OL}$) 704 is configured to receive an image of the average coil current ($V(I_{COIL\_AVG})$) and output voltage ($V_{COUT}$).

In embodiments, the image of the average coil current ($V(I_{COIL\_AVG})$) represents a voltage signal proportional to the average current flowing through the inductor 705 of the DC-DC power stage 702.

In embodiments, the capacitor current ($I_{COUT}$) 418 represents a voltage signal proportional to the current associated with the output capacitor ($C_{OUT}$) 106. This signal indicates the energy transferred to or from the output capacitor ($C_{OUT}$) 106. In the power converter system 700, the image of the capacitor current ($I'_{COUT}$) is created by a sense capacitor in the current estimator 712.

The feedback controller 714 of the feedback outer loop ($F_{OL}$) 704 is configured to generate a voltage error ($V_{ERR}$) based on these input signals, representing a difference from the reference voltage ($V_{REF}$) (i.e., desired set point). The feedback controller (714) receives the image of the average coil current ($V(I_{COIL\_AVG})$) minus the estimated image of the capacitor current ($I'_{COUT}$) 418 to determine the state of the system relative to the reference voltage ($V_{REF}$). The voltage error ($V_{ERR}$) indicates whether the voltage at load 108 is above or below the desired target.

In embodiments, the summer 710 has a first input coupled to the output of the feedback outer loop ($F_{OL}$) 704. A second input of the summer 710 is coupled to a slope compensator 708. Accordingly, the output of the summer 710 is the algebraic sum of these two signals. The summer 710 then adds or subtracts these two signals depending on their polarities. It produces an output to the feedback inner loop ($F_{IL}$) 706 that combines the instantaneous error voltage and the rate of change compensation (slope compensation).

The slope compensator 708 is configured to stabilize the inner control loop in the power converter system 700, which may exhibit sub-harmonic transient responses or become unstable. Slope compensator 708 can adjust the duty cycle reference (the control effort) based on a function of the output system variable or switching frequency, preventing subharmonic oscillations that can occur in Pulse Width Modulated (PWM) systems.

In embodiments, the feedback inner loop ($F_{IL}$) 706 includes a comparator 716 and a latch 718, which may or may not be arranged as shown. In embodiments, feedback inner loop ($F_{IL}$) 706 may include components not shown. In embodiments, feedback inner loop ($F_{IL}$) 706 is configured to receive a clock signal ($T_{CLK}$), an image of the peak coil current ($V(I_{COIL\_PEAK})$), and an output signal from the summer 710.

The clock signal ($T_{CLK}$) provides timing information and synchronizes the operation of the feedback inner loop ($F_{IL}$) 706 with the overall frequency of the power converter system 700. This ensures that the control actions taken by the feedback inner loop ($F_{IL}$) 706 are welltimed and consistent with other processes within the power converter system 700.

The image of the peak coil current ($V(I_{COIL\_PEAK})$) provides real-time data on the current through the inductor 705. The peak coil current ($V(I_{COIL\_PEAK})$) allows the feedback inner loop ($F_{IL}$) 706 to quickly adjust the inductor current to the peak value given by the output of the summer 710.

The feedback inner loop ($F_{IL}$) 706 also receives an output signal from summer 710 used to harmonize the regulation of the feedback inner loop ($F_{IL}$) 706 with the feedback outer loop ($F_{OL}$) 704.

The feedback inner loop ($F_{IL}$) 706 is configured to generate a pulse width modulation (PWM) signal based on these input signals, which is provided as an input signal to the DC-DC power stage 702 within the power converter system 700. The PWM output of the feedback inner loop ($F_{IL}$) 706 directly controls the switching circuit 703 in the DC-DC power stage 702, modulating their operation to convert input DC power to output DC power at desired voltage and current levels.

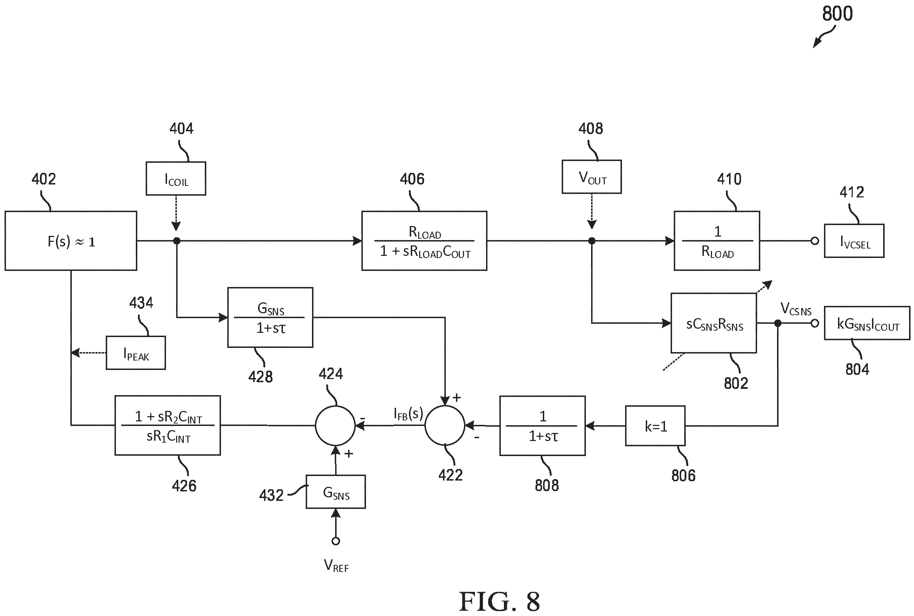

Figure 8 illustrates a block diagram of an embodiment control system 800, which may be implemented as the power converter system 700. Control system 800 illustrates a proposed arrangement that allows indirect measurement of the output current ($I_{VCSEL}$) 412 provided to the VCSEL through subtraction of the capacitor current ($I_{COUT}$) 418 from the coil current ($I_{COIL}$) 404. In embodiments, the output capacitor current observer is realized by a sense capacitor ($C_{SNS}$) and sense resistor ($R_{SNS}$), represented as the transfer function 802.

To maintain the conciseness of this disclosure, items bearing similar reference numerals in Figure 4 will not be reiterated in the description of Figure 8.

In the control system 800, the transfer function 416 in the control system 400 is replaced with the transfer function 802-the output capacitor current observer transfer function. In the frequency domain, transfer function 802 describes how the capacitor current ($I_{COUT}$) 418 is related to a representation of the sense voltage ($V_{CSNS}$) 804. Transfer function 802 is represented as $sC_{SNS}R_{SNS}$, where $C_{SNS}$ is the capacitance of a variable sense capacitor ($C_{SNS}$), and $R_{SNS}$ is the resistance of a sense resistor ($R_{SNS}$).

In embodiments, the variable sense capacitor ($C_{SNS}$) is arranged between the output voltage ($V_{OUT}$) 408 and a virtual ground, realized by, for example, an operational amplifier. In the time domain, the variable sense capacitor ($C_{SNS}$) produces a sense current ($I_{CSNS}$) from the output voltage ($V_{OUT}$) 408, which can be represented as: $I_{CSNS}(t) = C_{SNS}\frac{dV_{OUT}(t)}{dt}$.

In embodiments, the sense resistor ($R_{SNS}$) transforms the sense current ($I_{CSNS}$) and, in the time domain, produces a sense voltage ($V_{CSNS}$) 804, which can be represented as $V_{CSNS}(t) = R_{SNS}C_{SNS}\frac{dV_{OUT}(t)}{dt}$.

Accordingly, the variable sense capacitor ($C_{SNS}$) is used in the feedback loop in conjunction with the sense resistor ($R_{SNS}$) to sense the coil current ($I_{COIL}$) 404 flowing through the inductor 705 and convert it into a proportional, sense voltage ($V_{CSNS}$) 804. The sense voltage ($V_{CSNS}$) 804 is used for control and regulation purposes as an input to the unity factor 806. The variable sense capacitor ($C_{SNS}$) can smoothen out the input signal, similar to the function of the second filter in the control system 400. In embodiments, it is desirable to have $C_{SNS}R_{SNS}$ be equal to $kG_{SNS}C_{OUT}$. The variable sense capacitor ($C_{SNS}$) provides a variable $k$ factor, which can be programmable.

In embodiments, the gain ($G_{SNS}$) of the sense variable sense capacitor ($C_{SNS}$) in conjunction with the sense resistor ($R_{SNS}$) is approximately equal to 0.5.

The variable sense capacitor ($C_{SNS}$), combined with the sense resistor ($R_{SNS}$), eliminates the need for a dedicated capacitor current sensor, such as a resistive current sensor or a current transformer.

The programmable k-factor 420 in the control system 400 is replaced with a unity factor 806 in the control system 800, as the function of the programmable k-factor 420 is met through the variable sense capacitor ($C_{SNS}$) and the transfer function 802.

The second filter in the control system 400, represented as the transfer function 430 is replaced with a different second filter in the control system 800. Unlike the second filter in the control system 400, the second filter in the control system 800 does not include a gain ($G_{SNS}$), as the gain function is met through the variable sense capacitor ($C_{SNS}$) and the transfer function 802. Accordingly, the transfer function 808 is represented as $\frac{1}{1+s\tau}$. In some embodiments, the pole $(1+s\tau)$ of the second filter (represented as transfer function 808) may not be needed because the capacitor ripple current is typically low.

Accordingly, the open loop feedback ($FB_{OL}$) at the output of the transfer function 808 is:

$$FB_{OL}(s) = \frac{1+sR_2C_{INT}}{sR_1C_{INT}} \frac{G_{SNS}}{1+s\tau} \frac{1+s\left(C_{OUT}-\frac{C_{SNS}R_{SNS}}{G_{SNS}}\right)R_{OUT}}{1+sC_{OUT}R_{OUT}}$$

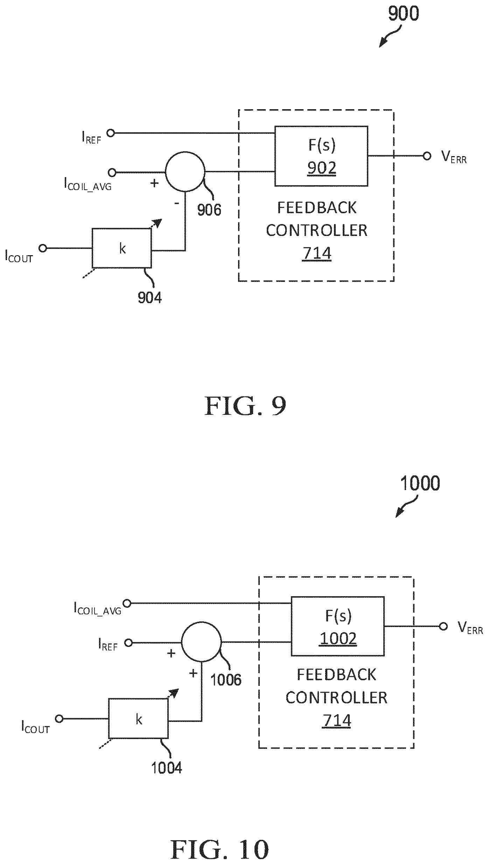

Figure 9 illustrates a block diagram of an embodiment feedback outer loop ($F_{OL}$) 900, which may be implemented as the feedback outer loop ($F_{OL}$) 704 in the power converter system 700. As shown, the feedback outer loop ($F_{OL}$) 900 includes a programmable k-factor 904, a summer 906, and the feedback controller 714, which may or may not be arranged as shown. In embodiments, feedback outer loop ($F_{OL}$) 900 may include components not shown.

Summer 906 receives the average coil current ($I_{COIL\_AVG}$) and the capacitor current ($I_{COUT}$) multiplied by the variable k factor and provides the difference between these signals at its output.

In the frequency domain, the transfer function 902 receives the reference current ($I_{REF}$) and the output of the summer 906 and generates the voltage error ($V_{ERR}$) based on these input signals.

In embodiments, the capacitor current ($I_{COUT}$) is measured by the variable sense capacitor ($C_{SNS}$) in conjunction with the sense resistor ($R_{SNS}$). In other embodiments, the capacitor current ($I_{COUT}$) is measured by a dedicated capacitor current sensor, such as a resistive shunt sensor or a current transformer.

Figure 10 illustrates a block diagram of an embodiment feedback outer loop ($F_{OL}$) 1000, which may be implemented as the feedback outer loop ($F_{OL}$) 704 in the power converter system 700. As shown, the feedback outer loop ($F_{OL}$) 1000 includes a programmable k-factor 1004, a summer 1006, and the feedback controller 714, which may or may not be arranged as shown. In embodiments, feedback outer loop ($F_{OL}$) 1000 may include components not shown.

Summer 1006 receives the reference current ($I_{REF}$) and the capacitor current ($I_{COUT}$) multiplied by the variable *k* factor and provides the sum of these signals at its output.

In the frequency domain, the transfer function 1002 receives the average coil current ($I_{COIL\_AVG}$) and the output of the summer 1006 and generates the voltage error ($V_{ERR}$) based on these input signals.

In embodiments, the capacitor current ($I_{COUT}$) is measured by the variable sense capacitor ($C_{SNS}$) in conjunction with the sense resistor ($R_{SNS}$). In other embodiments, the capacitor current ($I_{COUT}$) is measured by a dedicated capacitor current sensor, such as shunt resistive sensor or a current transformer.

In contrast to the feedback outer loop ($F_{OL}$) 900, in the feedback outer loop ($F_{OL}$) 1000, the output of the current estimator is not subtracted from average coil current ($I_{COIL\_AVG}$) but added to the reference signal (i.e.,

$I'_{REF} = I'_{COUT} + V_{REF}$, where $I'_{REF}$ is an image of the reference current ($I_{REF}$) and $I'_{COUT}$ is an estimated image of the capacitor current ($I_{COUT}$)). From the transfer function point of view, this is identical to that in Figure 9. However, advantageously, the current estimator is not inserted into the feedback in the feedback outer loop ($F_{OL}$) 1000, which does not degrade the phase stability margin.

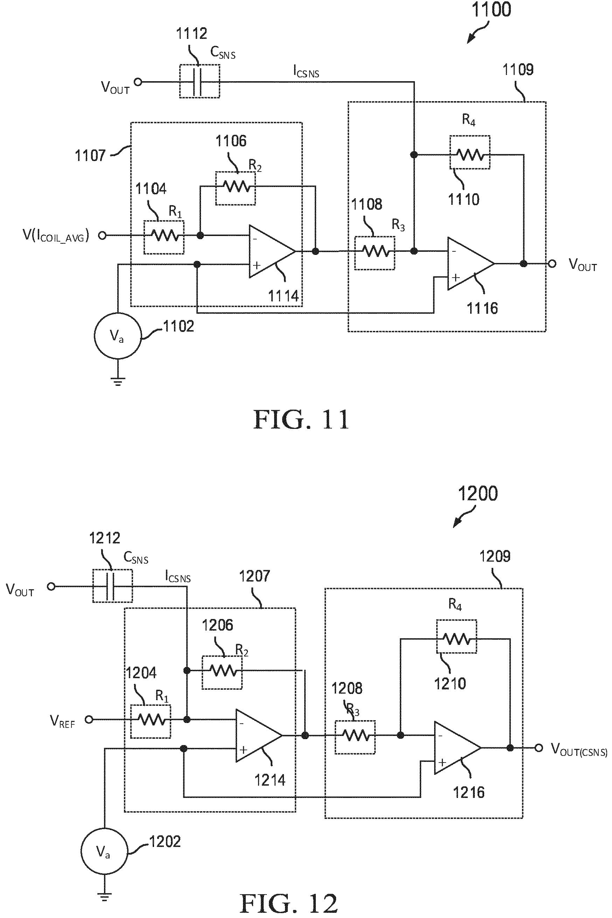

Figure 11 illustrates a schematic of an embodiment representing the current estimator circuit 1100, which may be implemented as the current estimator 712 in the power converter system 700 or current estimator (represented as the transfer function 802) in the control system 800. As shown, current estimator circuit 1100 includes a voltage source ($V_a$) 1102, a first resistor ($R_1$) 1104, a second resistor ($R_2$) 1106, a third resistor ($R_3$) 1108, a fourth resistor ($R_4$) 1110, a variable sense capacitor ($C_{SNS}$) 1112, a first operational amplifier 1114, and a second operational amplifier 1116, which may (or may not) be arranged as shown. Current estimator circuit 1100 may include additional components not shown.

The voltage source ($V_a$) 1102 provides a common mode voltage ($V_a$) to the non-inverting (+) inputs of the first operational amplifier 1114 and the second operational amplifier 1116. In embodiments, the value of the voltage source ($V_a$) 1102 is set to approximately half of the power supply voltage ($V_{DD}$) from the power supply 104.

In embodiments, the variable sense capacitor ($C_{SNS}$) 1112 is coupled between the output node of the DC-DC converter 102 (i.e., coupled to load 108) and the virtual ground terminal (-) of the first operational amplifier 1214 (i.e., equal to $V_a$). The sense current ($I_{CSNS}$) from the variable sense capacitor ($C_{SNS}$) 1112 is provided to the inverting (-) input of the second operational amplifier 1116, which is coupled to its output via the fourth resistor ($R_4$) 1110. The inverting (-) input of the second operational amplifier 1116 represents the virtual ground, equal to the voltage Va. The connection to the virtual ground allows the realization of $I_{CSNS}(t) = C_{SNS} \, dV_{OUT}(t)/dt$, where $I_{CSNS}(t)$ is transformed to the sense voltage ($V_{CSNS}$) on the fourth resistor ($R_4$) 1110.

The image of the average coil current ($I_{COIL\_AVG}$) is provided by a first inverting amplifier 1107, realized by the first operational amplifier 1214, the first resistor ($R_1$) 1204, and the second resistor ($R_2$) 1206. The output of the first operational amplifier 1114 is coupled to a second inverting amplifier 1109, composed from the second operational amplifier 1116, the third resistor ($R_3$) 1108, and the fourth resistor ($R_4$) 1110.

Current estimator circuit 1100 is arranged as an in-loop implementation where the estimated output capacitor current ($I_{COUT}$) represented by sense current ($I_{CSNS}$) from the variable sense capacitor ($C_{SNS}$) 1112 is subtracted from the average coil current ($I_{COIL\_AVG}$). The output voltage ($V_{OUT}$) is represented as $V_{OUT} = V(I_{COIL\text{-}AVG}) - V_{CSNS}(t)$ or $V_{OUT} = V$

$$(I_{COIL\_AVG}) - \quad R_{SNS}C_{SNS} \, dV_{OUT}(t)/dt \quad .$$

Advantageously, the feedback amplifier, realized as the transfer function 426 for the current estimator circuit 1100 operates within a well-defined common mode voltage.

Figure 12 illustrates a schematic of an embodiment current estimator circuit 1200, which may be implemented as the current estimator in the power converter system 700. As shown, current estimator circuit 1200 includes a voltage source ($V_a$) 1202, a first resistor ($R_1$) 11204, a second resistor ($R_2$) 1206, a third resistor ($R_3$) 1208, a fourth resistor ($R_4$) 1210, a variable sense capacitor ($C_{SNS}$) 1212, a first operational amplifier 1214, and a second operational amplifier 1216, which may (or may not) be arranged as shown. Current estimator circuit 1200 may include additional components not shown.

The voltage source ($V_a$) 1202 provides a reference voltage ($V_a$) to the non-inverting (+) inputs of the first operational amplifier 1214 and the second operational amplifier 1216.

In embodiments, the variable sense capacitor ($C_{SNS}$) 1212 is coupled between the output node of the DC-DC converter 102 (i.e., coupled to load 108) and the virtual ground terminal (-) of the first operational amplifier 1214 (i.e., equal to $V_a$). The sense current ($I_{CSNS}$) from the variable sense capacitor ($C_{SNS}$) 1112 is provided to the inverting (-) input of the first operational amplifier 1114, which is coupled to its output via the second resistor ($R_2$) 1206. The connection to the virtual ground allows the realization of $I_{CSNS}(t) = C_{SNS} \, dV_{OUT}(t)/dt$, where $I_{CSNS}(t)$ is transformed to the negative of the sense voltage (- $V_{CSNS}$) on the second resistor ($R_2$) 1206.

The reference voltage ($V_{REF}$) is provided to the input of a first inverting amplifier 1207, realized by the first operational amplifier 1214, the first resistor ($R_1$) 1204, and the second resistor ($R_2$) 1206. The output of the first operational amplifier, 1214, is coupled to the input of a second inverting amplifier 1209, composed from the second operational amplifier 1216, the third resistor ($R_3$) 1208, and the fourth resistor ($R_4$) 1210.

This second solution of the current estimator circuit 1200 is arranged in the path of the reference voltage ($V_{REF}$), such that the estimated image of the output capacitor current ($I_{COUT}$) represented by sense current ($I_{CSNS}$) from the variable sense capacitor ($C_{SNS}$) 1212 is added to the reference voltage ($V_{REF}$). The output voltage ($V_{OUT}$) is represented as $V_{OUT(CSNS)} = \quad V_{REF} + \ V_{CSNS}(t) \text{ or } V_{OUT(CSNS)} = V_{REF} + \ R_{SNS}C_{SNS} \, dV_{OUT}(t)/dt \quad .$

Advantageously, parasitic phase lag from the current estimator circuit 1200 does not impact the system's stability as it is outside feedback loop.

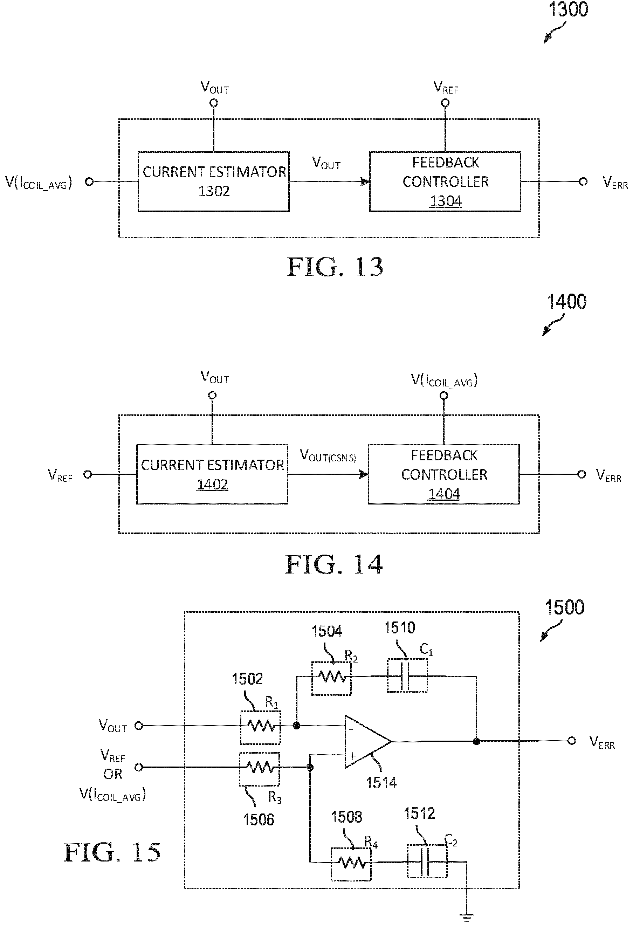

Figure 13 illustrates a block diagram of a feedback outer loop ($F_{OL}$) 1300, which may be implemented as the feedback outer loop ($F_{OL}$) 704 of the power converter system 700. The feedback outer loop ($F_{OL}$) 1300 includes a current estimator 1302 and a feedback controller 1304, which may (or may not) be arranged as shown. Feedback outer loop ($F_{OL}$) 1300 may include additional components not shown.

In embodiments, the current estimator 1302 is implemented in the feedback outer loop ($F_{OL}$) 704 as the current estimator 712 and within the feedback loop. In embodiments, current estimator 1302 is implemented as the current estimator circuit 1100 in Figure 11.

As shown in Figure 7, the input signals to the feedback outer loop ($F_{OL}$) 1300 are the image of the average coil current ($V(I_{COIL\_AVG})$), an image of the capacitor current ($I_{COUT}$), and the reference voltage ($V_{REF}$).

The current estimator 1302 receives the image of the average coil current ($V(I_{COIL\_AVG})$) and output voltage ($V_{OUT}$) The current estimator 1302 generates an output voltage ($V_{OUT}$), represented as

$$V(I_{COIL\_AVG}) - \quad R_{SNS}C_{SNS} \, dV_{OUT}(t)/dt \quad .$$

In embodiments, feedback controller 1404 is implemented as the feedback controller 714 in the power converter system 700. The feedback controller 1404 of the feedback outer loop ($F_{OL}$) 1400 is configured to generate a voltage error ($V_{ERR}$) based on the reference voltage ($V_{REF}$) and the output voltage ($V_{CSNS(OUT)}$) from the current estimator 1402. The voltage error ($V_{ERR}$) indicates whether the voltage at load 108 is above or below the desired target. The voltage error ($V_{ERR}$) is an input signal to the feedback inner loop ($F_{IL}$) 706 of the power converter system 700.

Figure 14 illustrates a block diagram of a feedback outer loop ($F_{OL}$) 1400, which may be implemented as the feedback outer loop ($F_{OL}$) 704 of the power converter system 700. The feedback outer loop ($F_{OL}$) 1400 includes a current estimator 1402 and a feedback controller 1404, which may (or may not) be arranged as shown. Feedback outer loop ($F_{OL}$) 1400 may include additional components not shown.

In embodiments, the current estimator 1402 is implemented as a part of the feedback outer loop ($F_{OL}$) 704 as the current estimator 712 and outside the feedback loop. In embodiments, current estimator 1402 is implemented as the current estimator circuit 1200 in Figure 12.

As shown in Figure 7, the input signals to the feedback outer loop ($F_{OL}$) 1400 are the image of the average coil current ($V(I_{COIL\_AVG})$), output voltage ($V_{OUT}$), and the reference voltage ($V_{REF}$).

The current estimator 1402 receives the image of the reference voltage ($V_{REF}$) and an image of the capacitor current ($I_{COUT}$). The current estimator 1302 generates an output voltage ($V_{OUT}$), represented as

$$V_{REF} - R_{SNS}C_{SNS}\ {dV_{OUT}(t)}/{dt}\ .$$

In embodiments, feedback controller 1404 is implemented as the feedback controller 714 in the power converter system 700. The feedback controller 1404 of the feedback outer loop ($F_{OL}$) 1400 is configured to generate a voltage error ($V_{ERR}$) based on the average coil current ($V(I_{COIL\_AVG})$) and the output voltage ($V_{OUT(CSNS)}$) from the current estimator 1402. The voltage error ($V_{ERR}$) indicates whether the voltage at load 108 is above or below the desired target. The voltage error ($V_{ERR}$) is an input signal to the feedback inner loop ($F_{IL}$) 706 of the power converter system 700.

Said differently, while the feedback outer loop ($F_{OL}$) 1300 is realized by applying an image of the capacitor current ($I'_{COUT}$) to the sensed average inductor current, the feedback outer loop ($F_{OL}$) 1400 applies the image of the capacitor current ($I'_{COUT}$) to the reference voltage ($V_{REF}$).

Figure 15 illustrates a schematic of an embodiment symmetrical feedback controller 1500, which may be implemented as the feedback controller 1304, 1404, 714 or PI regulator 300. Symmetric feedback controller 1500 includes a first resistor ($R_1$) 1502, a second resistor ($R_2$) 1504, a third resistor ($R_3$) 1506, a fourth resistor ($R_4$) 1508, a first capacitor ($C_1$) 1510, a second capacitor ($C_2$) 1512, and an operational amplifier 1514, which may (or may not) be arranged as shown. Symmetric feedback controller 1500 may include additional components not shown. In embodiments, the resistance of the first resistor ($R_1$) 1502 is approximately equal to the resistance of the second resistor ($R_2$) 1504. In embodiments, the resistance of the third resistor ($R_3$) 1506 is approximately equal to that of the fourth resistor ($R_4$) 1508. In embodiments, the capacitance of the first capacitor ($C_1$) 1510 is approximately equal to the capacitance of the second capacitor ($C_2$) 1512.

In contrast to the PI regulator 300, symmetrical feedback controller 1500 realizes symmetrical (i.e., identical) transfer function $V_{ERR}/V_{REF} = -V_{ERR}/V_{OUT}$.

The output voltage ($V_{OUT}$) from the current estimator in the feedback outer loop ($F_{OL}$) 1300 or feedback outer loop ($F_{OL}$) 1400 is provided to the first resistor ($R_1$) 1502. The output of the operational amplifier 1514 is coupled to its inverting (-) input via the second resistor ($R_2$) 1504 and the first capacitor ($C_1$) 1510.

The reference voltage ($V_{REF}$) or the average coil current ($V(I_{COIL\_AVG})$) is provided to the third resistor ($R_3$) 1506. The non-inverting (+) input of the operational amplifier 1514 is coupled to reference ground via the fourth resistor ($R_4$) 1508 and the second capacitor ($C_2$) 1512. The fourth resistor ($R_4$) 1508 and the second capacitor ($C_2$) 1512 allow symmetry in the frequency domain from both inputs (i.e., equal transfer functions with different polarity).

In embodiments, the operational amplifier 1514 generates the voltage error ($V_{ERR}$) based on a difference between (i) the output voltage ($V_{OUT}$) from the feedback outer loop ($F_{OL}$) 1300 and (ii) the reference voltage ($V_{REF}$).

In embodiments, the operational amplifier 1514 generates the voltage error ($V_{ERR}$) based on a difference between (i) the output voltage ($V_{OUT}$) from the feedback outer loop ($F_{OL}$) 1400 and (ii) the average coil current ($V(I_{COIL\_AVG})$).

Advantageously, embodiments of this disclosure provide a better control of the rise time for the DC-DC power converter, while minimizing the risk of overshoot.

A first aspect relates to a feedback circuit for a power converter system. The feedback circuit includes an outer loop circuit and an inner loop circuit. The outer loop circuit includes a current estimator and a feedback controller. The current estimator is configured to generate a first voltage based on a difference between an output current of the power converter system and an average current at an inductor of the power converter system. The feedback controller is configured to generate an error signal as a difference between the first voltage and a desired setpoint voltage. The inner loop circuit is configured to generate a pulse width modulation (PWM) signal to operate switching elements of the power converter system based on the error signal.

In a first implementation form of the feedback circuit according to the first aspect as such, the power converter system is configured to provide a regulated current to a vertical-cavity surface-emitting laser (VCSEL) driver, the VCSEL driver configured to drive a VCSEL.

In a second implementation form of the feedback circuit according to the first aspect as such or any preceding implementation form of the first aspect, the power converter system includes a variable sense capacitor arranged in parallel with a load of the power converter system; and a sense resistor having a first terminal coupled to the variable sense capacitor, a second terminal of the sense resistor coupled to the load.

In a third implementation form of the feedback circuit according to the first aspect as such or any preceding implementation form of the first aspect, the power converter system comprises a DC-DC power stage comprising switching elements. The switching elements include a high-side switch and a low-side switch. A shared terminal of the high-side switch and the low-side switch is coupled to a first terminal of the inductor. A second terminal of the inductor is coupled to a load of the power converter system.

In a fourth implementation form of the feedback circuit according to the first aspect as such or any preceding implementation form of the first aspect, the feedback circuit further includes a slope compensator and a summer. The summer is coupled in between the outer loop circuit and the inner loop circuit. The summer is configured to generate an algebraic sum of the signal from the slope compensator and the error signal to the inner loop circuit.

In a fifth implementation form of the feedback circuit according to the first aspect as such or any preceding implementation form of the first aspect, a load of the power converter system is a vertical-cavity surface-emitting laser (VCSEL).

In a sixth implementation form of the feedback circuit according to the first aspect as such or any preceding implementation form of the first aspect, the power converter system is configured to provide a regulated current to operate a vertical-cavity surface-emitting laser (VCSEL).

A second aspect relates to a feedback circuit for a power converter system. The feedback circuit includes an outer loop circuit and an inner loop circuit. The outer loop circuit includes a current estimator and a feedback controller. The current estimator is configured to generate a first voltage based on a difference between an output current of the power converter system and a desired setpoint voltage. The feedback controller is configured to generate an error signal as a difference between the first voltage and an average current at an inductor of the power converter system. The inner loop circuit is configured to generate a pulse width modulation (PWM) signal to operate switching elements of the power converter system based on the error signal.

In a first implementation form of the feedback circuit according to the second aspect as such, the power converter system is configured to provide a regulated current to a vertical-cavity surface-emitting laser (VCSEL) driver, the VCSEL driver configured to drive a VCSEL.

In a second implementation form of the feedback circuit according to the second aspect as such or any preceding implementation form of the second aspect, the power converter system includes a variable sense capacitor arranged in parallel with a load of the power converter system; and a sense resistor having a first terminal coupled to the variable sense capacitor, a second terminal of the sense resistor coupled to the load.

In a third implementation form of the feedback circuit according to the second aspect as such or any preceding implementation form of the second aspect, the power converter system includes a DC-DC power stage comprising switching elements. The switching elements include a high-side switch and a low-side switch. A shared terminal of the high-side switch and the low-side switch is coupled to a first terminal of the inductor. A second terminal of the inductor is coupled to a load of the power converter system.

In a fourth implementation form of the feedback circuit according to the second aspect as such or any preceding implementation form of the second aspect, the feedback circuit further includes a slope compensator and a summer. The summer is coupled in between the outer loop circuit and the inner loop circuit. The summer is configured to generate an algebraic sum of the signal from the slope compensator and the error signal to the inner loop circuit.

In a fifth implementation form of the feedback circuit according to the second aspect as such or any preceding implementation form of the second aspect, a load of the power converter system is a vertical-cavity surface-emitting laser (VCSEL).

In a sixth implementation form of the feedback circuit according to the second aspect as such or any preceding implementation form of the second aspect, the power converter system is configured to provide a regulated current to operate a vertical-cavity surface-emitting laser (VCSEL).

A third aspect relates to a power converter system. The power converter system includes a DC-DC power stage and a feedback circuit. The DC-DC power stage includes switching elements and an inductor. The switching elements include a high-side switch and a low-side switch. A shared terminal of the high-side switch and the low-side switch is coupled to a first terminal of the inductor. A second terminal of the inductor is coupled to a load of the power converter system. The feedback circuit is configured to regulate an output current of the DC-DC power stage for the load. The feedback circuit includes an outer loop circuit and an in inner loop circuit. The outer loop circuit includes a current estimator and a feedback controller. The current estimator is configured to generate a first voltage based on a difference between the output current and an average current at the inductor or based on a difference between the output and a desired setpoint voltage. The feedback controller is configured to generate an error signal as a difference between the first voltage and the desired setpoint voltage or as a difference between the first voltage and the average current at the inductor. The inner loop circuit is configured to generate a pulse width modulation (PWM) signal to operate switching elements of the power converter system based on the error signal.

In a first implementation form of the power converter system according to the third aspect as such, the power converter system is configured to provide a regulated current to a vertical-cavity surface-emitting laser (VCSEL) driver, the VCSEL driver configured to drive a VCSEL.

In a second implementation form of the power converter system according to the third aspect as such or any preceding implementation form of the third aspect, the power converter system further includes a variable sense capacitor arranged in parallel with the load; and a sense resistor having a first terminal coupled to the variable sense capacitor, a second terminal of the sense resistor coupled to the load.

In a third implementation form of the power converter system according to the third aspect as such or any preceding implementation form of the third aspect, the feedback circuit further includes a slope compensator and a summer. The summer is coupled in between the outer loop circuit and the inner loop circuit. The summer is configured to generate an algebraic sum of the signal from the slope compensator and the error signal to the inner loop circuit.

In a fourth implementation form of the power converter system according to the third aspect as such or any preceding implementation form of the third aspect, the load is a vertical-cavity surface-emitting laser (VCSEL).

In a fifth implementation form of the power converter system according to the third aspect as such or any preceding implementation form of the third aspect, the power converter system is configured to provide a regulated current to operate a vertical-cavity surface-emitting laser (VCSEL).

Although the description has been described in detail, it should be understood that various changes, substitutions, and alterations may be made without departing from the spirit and scope of this disclosure as defined by the appended claims. The same elements are designated with the same reference numbers in the various figures. Moreover, the scope of the disclosure is not intended to be limited to the particular embodiments described herein, as one of ordinary skill in the art will readily appreciate from this disclosure that processes, machines, manufacture, compositions of matter, means, methods, or steps, presently existing or later to be developed, may perform substantially the same function or achieve substantially the same result as the corresponding embodiments described herein. Accordingly, the appended claims are intended to include within their scope such processes, machines, manufacture, compositions of matter, means, methods, or steps.

The specification and drawings are, accordingly, to be regarded simply as an illustration of the disclosure as defined by the appended claims, and are contemplated to cover any and all modifications, variations, combinations, or equivalents that fall within the scope of the present disclosure.

**Claims**

1. A feedback circuit for a power converter system (700), the feedback circuit comprising:

   an outer loop circuit (704), comprising:

   a current estimator (712, 1302) configured to generate a first voltage based on a difference between an output current of the power converter system (700) and an average current at an inductor (705) of the power converter system (700), and
   a feedback controller (714, 1304) configured to generate an error signal as a difference between the first voltage and a desired setpoint voltage; and

   an inner loop circuit (706) configured to generate a pulse width modulation (PWM) signal to operate switching elements (703) of the power converter system (700) based on the error signal.

2. The feedback circuit of claim 1, wherein the power converter system (700) is configured to provide a regulated current to a vertical-cavity surface-emitting laser (VCSEL) driver, the VCSEL driver configured to drive a VCSEL.

3. The feedback circuit of claim 1, wherein the power converter system (700) comprises:

   a variable sense capacitor arranged in parallel with a load (108) of the power converter system (700); and
   a sense resistor having a first terminal coupled to the variable sense capacitor, a second terminal of the sense resistor coupled to the load (108).

4. The feedback circuit of claim 1, wherein the power converter system (700) comprises a DC-DC power stage (702) comprising switching elements (703), wherein the switching elements (703) include a high-side switch and a low-side switch, wherein a shared terminal of the high-side switch and the low-side switch is coupled to a first terminal of the inductor (705), and wherein a second terminal of the inductor (705) is coupled to a load (108) of the power converter system (700).

5. The feedback circuit of claim 1, further comprising a slope compensator (708) and a summer (710), the summer (710) coupled in between the outer loop circuit (704) and the inner loop circuit (706), the summer (710) configured to generate an algebraic sum of the signal from the slope compensator (708) and the error signal to the inner loop circuit (706).

6. The feedback circuit of claim 1, wherein a load (108) of the power converter system (700) is a vertical-cavity surface-emitting laser (VCSEL).

7. The feedback circuit of claim 1, wherein the power converter system (700) is configured to provide a regulated current to operate a vertical-cavity surface-emitting laser (VCSEL).

8. A feedback circuit for a power converter system (700), the feedback circuit comprising:

an outer loop circuit (704), comprising:

a current estimator (712, 1402) configured to generate a first voltage based on a difference between an output current of the power converter system (700) and a desired setpoint voltage, and
a feedback controller (714, 1404) configured to generate an error signal as a difference between the first voltage and an average current at an inductor (705) of the power converter system (700); and

an inner loop circuit (706) configured to generate a pulse width modulation (PWM) signal to operate switching elements (703) of the power converter system (700) based on the error signal.

9. The feedback circuit of claim 8, wherein the power converter system (700) is configured to provide a regulated current to a vertical-cavity surface-emitting laser (VCSEL) driver, the VCSEL driver configured to drive a VCSEL.

10. The feedback circuit of claim 8, wherein the power converter system (700) comprises:

a variable sense capacitor arranged in parallel with a load (108) of the power converter system (700); and
a sense resistor having a first terminal coupled to the variable sense capacitor, a second terminal of the sense resistor coupled to the load (108).

11. The feedback circuit of claim 8, wherein the power converter system (700) comprises a DC-DC power stage (702) comprising switching elements (703), wherein the switching elements (703) include a high-side switch and a low-side switch, wherein a shared terminal of the high-side switch and the low-side switch is coupled to a first terminal of the inductor (705), and wherein a second terminal of the inductor (705) is coupled to a load (108) of the power converter system (700).

12. The feedback circuit of claim 8, further comprising a slope compensator (708) and a summer (710), the summer (710) coupled in between the outer loop circuit (704) and the inner loop circuit (706), the summer (710) configured to generate an algebraic sum of the signal from the slope compensator (708) and the error signal to the inner loop circuit (706).

13. The feedback circuit of claim 8, wherein a load (108) of the power converter system (700) is a vertical-cavity surface-emitting laser (VCSEL).

14. The feedback circuit of claim 8, wherein the power converter system (700) is configured to provide a regulated current to operate a vertical-cavity surface-emitting laser (VCSEL).

15. A power converter system (700), comprising:

a DC-DC power stage (702) comprising switching elements (703) and an inductor (705), wherein the switching elements (703) include a high-side switch and a low-side switch, wherein a shared terminal of the high-side switch and the low-side switch is coupled to a first terminal of the inductor (705), and wherein a second terminal of the inductor (705) is coupled to a load (108) of the power converter system (700);
a feedback circuit configured to regulate an output current of the DC-DC power stage (702) for the load (108), the feedback circuit comprising:

an outer loop circuit (704), comprising:

a current estimator (712, 1302, 1402) configured to generate a first voltage based on a difference between the output current and an average current at the inductor (705) or based on a difference between the output and a desired setpoint voltage, and

a feedback controller (714, 1304, 1404) configured to generate an error signal as a difference between the first voltage and the desired setpoint voltage or as a difference between the first voltage and the average current at the inductor (705); and

an inner loop circuit (706) configured to generate a pulse width modulation (PWM) signal to operate switching elements (703) of the power converter system (700) based on the error signal.

16. The power converter system (700) of claim 15, wherein the power converter system (700) is configured to provide a regulated current to a vertical-cavity surface-emitting laser (VCSEL) driver, the VCSEL driver configured to drive a VCSEL.

17. The power converter system (700) of claim 15, the power converter system (700) comprises:

a variable sense capacitor arranged in parallel with the load (108); and
a sense resistor having a first terminal coupled to the variable sense capacitor, a second terminal of the sense resistor coupled to the load (108).

18. The power converter system (700) of claim 15, wherein the feedback circuit further comprises a slope compensator (708) and a summer (710), the summer (710) coupled in between the outer loop circuit (704) and the inner loop circuit (706), the summer (710) configured to generate an algebraic sum of the signal from the slope compensator (708) and the error signal to the inner loop circuit (706).

19. The power converter system (700) of claim 15, wherein the load (108) is a vertical-cavity surface-emitting laser (VCSEL).

20. The power converter system (700) of claim 15, wherein the power converter system (700) is configured to provide a regulated current to operate a vertical-cavity surface-emitting laser (VCSEL).

100

POWER SUPPLY
104

$V_{REF}$

($I_{REF}$)

DC-DC CONVERTER
102

AVERAGE CURRENT SENSE

$C_{OUT}$

106

LOAD
108

FIG. 1

300

$R_2$

$C_{INT}$

$R_1$

304

306

302

308

FIG. 3

FIG. 2

FIG. 4

FIG. 5A

FIG. 5B

600

602

604

606

MAGNITUDE (dB)

FREQUENCY

## FIG. 6A

650

652

654

656

0

-90

-180

PHASE (DEG)

FREQUENCY

## FIG. 6B

700

PWM

DC-DC POWER STAGE 702
703
705

V(I_COIL_PEAK)

V(I_COIL_AVG)

106

C_OUT

LOAD 108

V_BUCK

OUTER LOOP 704
712
714

V_REF

710

V_ERR

SLOPE COMPENSATOR 708

INNER LOOP 706
716
718

T_CLK

FIG. 7

FIG. 8

900

$I_{REF}$

$I_{COIL\_AVG}$

+

−

906

$I_{COUT}$

k

904

F(s)

902

$V_{ERR}$

FEEDBACK
CONTROLLER

714

## FIG. 9

1000

$I_{COIL\_AVG}$

$I_{REF}$

+

+

1006

$I_{COUT}$

k

1004

F(s)

1002

$V_{ERR}$

FEEDBACK
CONTROLLER

714

## FIG. 10

FIG. 11

FIG. 12

1300

V(I_COIL_AVG) ○

V_OUT

CURRENT ESTIMATOR
1302

V_OUT

V_REF

FEEDBACK
CONTROLLER
1304

○ V_ERR

FIG. 13

1400

V_REF ○

V_OUT

CURRENT ESTIMATOR
1402

V_OUT(CSNS)

V(I_COIL_AVG)

FEEDBACK
CONTROLLER
1404

○ V_ERR

FIG. 14

1500

V_OUT ○

V_REF
OR
V(I_COIL_AVG) ○

1502 R_1

1504 R_2    1510 C_1

1506 R_3

1508 R_4    1512 C_2

1514

○ V_ERR

FIG. 15

Europäisches
Patentamt

European
Patent Office

Office européen
des brevets

## EUROPEAN SEARCH REPORT

**Application Number**

EP 25 15 3812

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SANTA CONCEPCION HUERTA ET AL: "Advanced Control for Very Fast DC-DC Converters Based on Hysteresis of the ${C}_{out}$ Current", IEEE TRANSACTIONS ON CIRCUITS AND SYSTEMS I: REGULAR PAPERS, IEEE, US, vol. 60, no. 4, 1 April 2013 (2013-04-01), pages 1052-1061, XP011498550, ISSN: 1549-8328, DOI: 10.1109/TCSI.2012.2209308 * page 2; figures 1, 4, 5 * | 1-20 | INV. H02M3/156 H02M1/00 H05B45/30 H01S5/068 |
| A | ABE SEIYA ET AL: "Current spike reduction technique for high power laser diode driver with pulse current output", 2017 IEEE 12TH INTERNATIONAL CONFERENCE ON POWER ELECTRONICS AND DRIVE SYSTEMS (PEDS), IEEE, 12 December 2017 (2017-12-12), XP033320317, DOI: 10.1109/PEDS.2017.8289197 [retrieved on 2018-02-09] * page 1.148; figure 2(b) * * abstract * | 2,6,7,9, 13,14, 16,19,20 | |
| A | EP 3 935 363 B1 (PSEMI CORP [US]) 29 November 2023 (2023-11-29) * claim 1 * | 3,10,17 | TECHNICAL FIELDS SEARCHED (IPC)  H02M H05B H01S |

The present search report has been drawn up for all claims

| Place of search | Date of completion of the search | Examiner |
|---|---|---|
| The Hague | 16 May 2025 | Zeljkovic, Sandra |

EPO FORM 1503 03.82 (P04C01)

# EP 4 593 276 A1

## ANNEX TO THE EUROPEAN SEARCH REPORT
## ON EUROPEAN PATENT APPLICATION NO.

EP 25 15 3812

16-05-2025

| Patent document cited in search report | | Publication date | Patent family member(s) | | Publication date |
|---|---|---|---|---|---|
| EP 3935363 | B1 | 29-11-2023 | CN | 113677969 A | 19-11-2021 |
| | | | CN | 119469526 A | 18-02-2025 |
| | | | EP | 3935363 A1 | 12-01-2022 |
| | | | JP | 7530549 B2 | 08-08-2024 |
| | | | JP | 2022523575 A | 25-04-2022 |
| | | | KR | 20210125105 A | 15-10-2021 |
| | | | US | 2020284679 A1 | 10-09-2020 |
| | | | US | 2022065723 A1 | 03-03-2022 |
| | | | US | 2024247991 A1 | 25-07-2024 |
| | | | WO | 2020180541 A1 | 10-09-2020 |

EPO FORM P0459